# EUROPEAN PATENT APPLICATION

(11) **EP 4 782 921 A1**
(43) Date of publication of application: **29.07.2026**
(21) Application number: 24868119.9
(22) Date of filing: 04.09.2024
(51) Int. Cl.: G03F 7/038, C08G 59/46, C08G 73/10, G03F 7/004, G03F 7/037, H05K 1/03

(54) **NEGATIVE PHOTOSENSITIVE RESIN COMPOSITION, NEGATIVE PHOTOSENSITIVE RESIN COMPOSITION COATING FILM, NEGATIVE PHOTOSENSITIVE RESIN COMPOSITION FILM, CURED FILM, AND ELECTRONIC COMPONENT USING SAME**

(30) Priority: 22.09.2023 JP 2023156681
(71) Applicant: Toray Industries, Inc., Tokyo 103-8666 (JP)
(72) Inventor: KATO Keigo, Otsu-shi, Shiga 520-8558 (JP); MATSUMURA Kazuyuki, Otsu-shi, Shiga 520-8558 (JP); TATEOKA Yoshiko, Otsu-shi, Shiga 520-8558 (JP)
(74) Representative: Kador & Partner Part mbB
(86) International application number: PCT/JP2024/031656
(87) International publication number: WO 2025/063041

(57) **Abstract**

A negative photosensitive resin composition comprising a cationic polymerizable compound as Component (A) and a photocationic polymerization initiator as Component (B), wherein Component (A) contains, as Component (A1), a polyfunctional aromatic glycidyl ether having an epoxy equivalent of 80 to 145 g/eq and having at least two or more epoxy groups in a molecule, and a content of Component (A1) in the total Component (A) is 45 to 100% by mass. Provided is a negative photosensitive resin composition suitable for bonding applications of semiconductor elements and electronic components, which achieves both excellent resolution and adhesion.

## Description

### TECHNICAL FIELD

The present invention relates to a negative photosensitive resin composition, a negative photosensitive resin composition coating film, a negative photosensitive resin composition film, a cured film, and a semiconductor device using these. More specifically, the present invention relates to a resin composition, a resin composition coating film, a resin composition film, a cured film, and a semiconductor device using these, which are suitably used for a surface protective film of a semiconductor element or an electronic component, an interlayer insulating film, a structure of MEMS (Micro Electro Mechanical Systems), or a bonding member.

### BACKGROUND ART

In electronic components such as semiconductor elements and MEMS, photosensitive materials are used as interlayer insulating films, surface protective films, and structural members. Photosensitive materials are classified into positive-type photosensitive materials using a diazonaphthoquinone compound or the like, and negative photosensitive materials using a photopolymerizable compound. Major negative photosensitive materials include photoradical polymerization-based materials using a radical polymerizable compound such as an acrylic compound and a photoradical polymerization initiator, and materials of photocationic polymerization system using a cationic polymerizable compound such as an epoxy compound and a photocationic polymerization initiator. In particular, negative photosensitive materials of photocationic polymerization system are suitably used as interlayer insulating films and structural members because they have excellent resolution and low shrinkage during pattern formation (for example, Patent Document 1).

In a manufacturing process of the electronic components and the like, a technology has been proposed in which a pattern is formed on a substrate using a photosensitive material, and another substrate is placed opposite to the formed pattern and bonded to each other by thermocompression. Examples thereof include a method for connecting electrode pads formed on an integrated circuit element (Patent Document 2), a method for bonding circuit boards (Patent Document 3), a method for manufacturing a semiconductor package (Patent Document 4), and the like. In recent years, particularly in electronic components such as MEMS, it has been required to replace metal materials, which have been conventionally used to bond substrates together, with photosensitive materials for cost reduction, size reduction, and lower profile. To meet such requirements, there is a demand for a photosensitive material that achieves both resolution capable of forming fine patterns and good adhesion.

### PRIOR ART DOCUMENTS

### PATENT DOCUMENTS

Patent Document 1: JP 5247396 B
Patent Document 2: JP 3050345 B
Patent Document 3: JP 2660943 B
Patent Document 4: JP 2003-347357 A

### SUMMARY OF INVENTION

### PROBLEMS TO BE SOLVED BY THE INVENTION

However, in using conventionally known photosensitive resin compositions for bonding applications of semiconductor elements and electronic components, there has been a problem in achieving both resolution and adhesion. Regarding positive-type photosensitive materials, although the resolution is excellent, there is a concern that gas is generated from a photosensitizer such as a diazonaphthoquinone compound during thermal curing, which causes voids at the bonding interface and reduces the bonding strength. In photoradical polymerization-based negative photosensitive materials, the resolution is insufficient, and there is a concern that the adhesion decreases due to large internal stress caused by curing shrinkage. Furthermore, although negative photosensitive materials of photocationic polymerization system such as those in Patent Document 1 have excellent resolution, the high photoreactivity of the cationic polymerizable compound results in a high crosslinking density after pattern formation, which leads to a problem that voids are generated on the bonding surface when substrates are thermocompression-bonded.

In view of such circumstances, an object of the present invention is to provide a negative photosensitive resin composition suitable for the bonding applications, which achieves both excellent resolution and adhesion.

### SOLUTIONS TO PROBLEMS

As a result of intensive studies, the inventors have found that, in a negative photosensitive resin composition containing a cationic polymerizable compound and a photocationic polymerization initiator, excellent resolution and adhesion can both be achieved by intentionally suppressing the photocationic polymerization reactivity to a certain level or less. Specifically, the inventors have found that by making the negative photosensitive resin composition contain a certain amount or more of a polyfunctional aromatic glycidyl ether having an epoxy equivalent within a specific range, the photocationic polymerization reactivity can be suppressed to a certain level or less, and it is possible to provide a negative photosensitive resin composition suitable for bonding applications of semiconductor elements and electronic components, which achieves both excellent resolution and adhesion.

The present invention is as follows.
<1> A negative photosensitive resin composition comprising a cationic polymerizable compound as Component (A) and a photocationic polymerization initiator as Component (B),
   wherein Component (A) contains, as Component (A1), a polyfunctional aromatic glycidyl ether having an epoxy equivalent of 80 to 145 g/eq and having at least two or more epoxy groups in a molecule, and
   the content of Component (A1) in the total Component (A) is 45 to 100% by mass.
<2> The negative photosensitive resin composition according to <1>, wherein the content of Component (A) in the total negative photosensitive resin composition is 45 to 70% by mass.
<3> The negative photosensitive resin composition according to <1> or <2>, wherein Component (A1) contains a liquid polyfunctional aromatic glycidyl ether having a viscosity at 25°C of 10,000 to 150,000 mPa·s.
<4> The negative photosensitive resin composition according to any of <1> to <3>, wherein Component (A) contains a cationic polymerizable compound selected from compounds represented by the following general formulas (1) and (2): 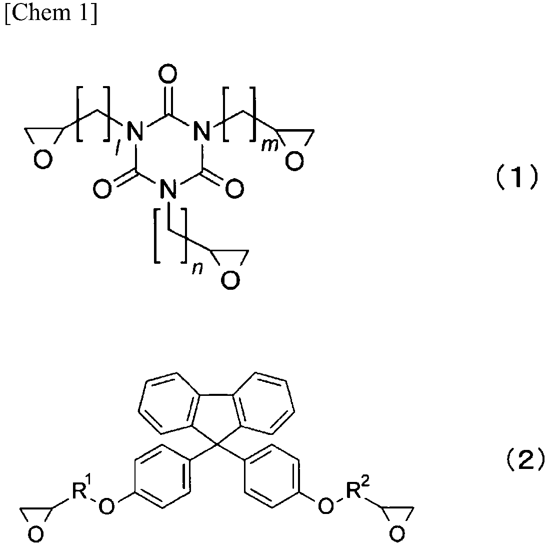 wherein, in general formula (1), l, m, and n are each independently an integer of 1 to 6; and in general formula (2), R^{I} and R² are each independently a divalent organic group.
<5> The negative photosensitive resin composition according to any of <1> to <4>, further comprising at least one polymer compound selected from polyamide, polyimide, and polyamide-imide as Component (C).
<6> The negative photosensitive resin composition according to <5>, wherein Component (C) contains a diamine residue derived from any of diamines of the following general formulas (3) to (7): 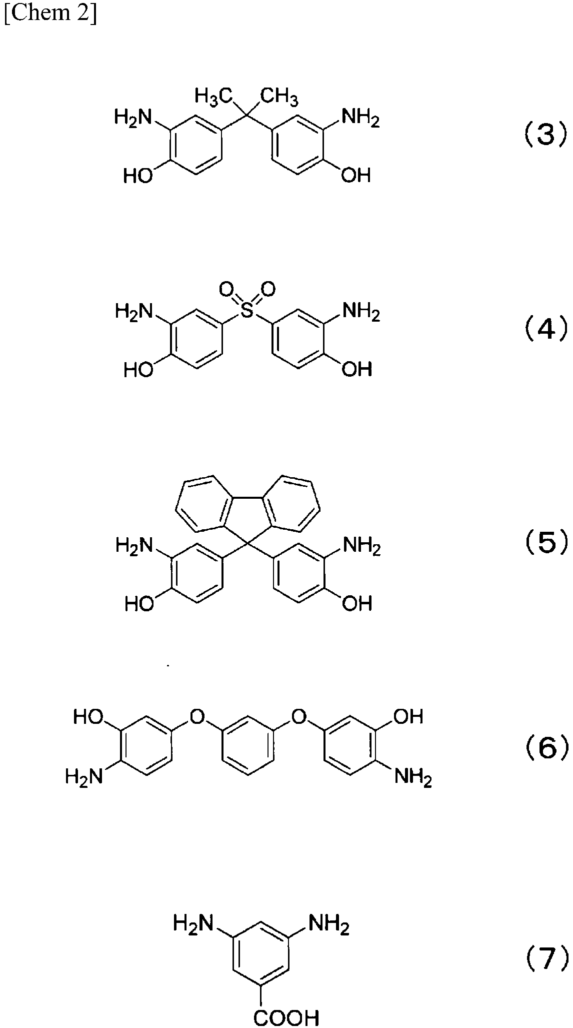
<7> A negative photosensitive resin composition coating film comprising the negative photosensitive resin composition according to any of <1> to <6>.
<8> A negative photosensitive resin composition film comprising the negative photosensitive resin composition coating film according to <7> and a support.
<9> A cured film obtained by curing the negative photosensitive resin composition according to any of <1> to <6> or the negative photosensitive resin composition coating film according to <7>.
<10> An electronic component comprising the cured film according to <9>.
<11> An electronic component comprising a structure in which two substrates are bonded via the cured film according to <9>.

### EFFECTS OF THE INVENTION

The present invention can provide a negative photosensitive resin composition, a negative photosensitive resin composition coating film, a negative photosensitive resin composition film, a cured film, and an electronic component using these, which are suitable for bonding applications of semiconductor elements and electronic components and which achieve both excellent resolution and adhesion.

### EMBODIMENTS OF THE INVENTION

The negative photosensitive resin composition of the present invention is a negative photosensitive resin composition comprising a cationic polymerizable compound as Component (A) and a photocationic polymerization initiator as Component (B),
wherein Component (A) contains, as Component (Al), a polyfunctional aromatic glycidyl ether having an epoxy equivalent of 80 to 145 g/eq and having at least two or more epoxy groups in a molecule,
and the content of Component (A1) in the total Component (A) is 45 to 100% by mass.

### <Component (A)>

The negative photosensitive resin composition of the present invention contains a cationic polymerizable compound as Component (A) (hereinafter sometimes referred to as "(A) cationic polymerizable compound"). By containing the (A) cationic polymerizable compound, the negative photosensitive resin composition of the present invention undergoes photocationic polymerization and is excellent in negative pattern processability.

Preferred examples of the (A) cationic polymerizable compound include cyclic ether compounds (such as epoxy compounds and oxetane compounds), ethylenically unsaturated compounds (such as vinyl ethers and styrenes), bicyclo-orthoesters, spiro-orthocarbonates, and spiro-orthoesters.

In the negative photosensitive resin composition of the present invention, the Component (A) contains, as Component (A1), a polyfunctional aromatic glycidyl ether having an epoxy equivalent of 80 to 145 g/eq and having at least two or more epoxy groups in a molecule. By containing the Component (A1), the degree of reaction of cationic polymerizable groups in the total Component (A) during pattern processing decreases, and the resin composition becomes flexible, whereby adhesion is improved. As a result, even under conditions of lower temperature and lower pressure, voids do not occur on the bonding surface when bonding to a substrate. Although the principle by which the degree of reaction of cationic polymerizable groups decreases by containing the Component (A1) is not clear, it is presumed that the nucleophilicity and molecular mobility of the cationic polymerizable compound contribute thereto. Cationic polymerization proceeds through an activation reaction, an initiation reaction, and a propagation reaction of a cationic polymerizable compound with an acid, and the nucleophilicity of the cationic polymerizable compound affects the reactivity of the propagation reaction. Since the electron density of an oxygen atom affects the nucleophilicity of an epoxy compound, it is presumed that when an alicyclic epoxy compound or the like often used in a typical negative photosensitive material of photocationic polymerization system is used, the nucleophilicity becomes high due to the electron-donating property of the alicyclic structure. On the other hand, it is presumed that when an aromatic glycidyl ether is used, the nucleophilicity becomes low due to the effects of electron-withdrawing properties and resonance stabilization of the aromatic ring, so that the cationic polymerization reactivity decreases. Furthermore, considering molecular mobility, it is presumed that in an epoxy compound having a low epoxy equivalent, the mobility of the system remarkably decreases with only a slight progress of the reaction, so the degree of reaction tends to be low. Therefore, the epoxy equivalent of the Component (A1) is 145 g/eq or less. In addition, since the degree of reaction decreases too much if the epoxy equivalent is too low, the epoxy equivalent of the Component (A1) is 80 g/eq or more. For the reasons described above, it is presumed that the degree of reaction of cationic polymerizable groups decreases by containing the Component (A1).

Furthermore, in the negative photosensitive resin composition of the present invention, the content of the Component (A1) in the total Component (A) is 45 to 100% by mass. When the content of the Component (A1) is the lower limit or more, the degree of cationic polymerization reaction of the total Component (A) is sufficiently lowered, and the resin composition becomes flexible, whereby adhesion is improved, and voids do not occur on the bonding surface when bonding to a substrate. Moreover, the content of the Component (A1) in the total Component (A) is preferably 45 to 80% by mass. The lower limit of the content is more preferably 50% by mass or more, and even more preferably 60% by mass or more. The upper limit of the content is more preferably 70% by mass or less. When the content of the Component (A1) is the lower limit of the preferred range or more, adhesion is improved as described above, and when it is the upper limit of the preferred range or less, resolution during pattern processing is improved, and internal stress after curing is reduced, which is preferable.

As the polyfunctional aromatic glycidyl ether corresponding to the Component (A1), for example, compounds represented by the following chemical formulas (A1-1), (A1-2), and (A1-3) can be used.

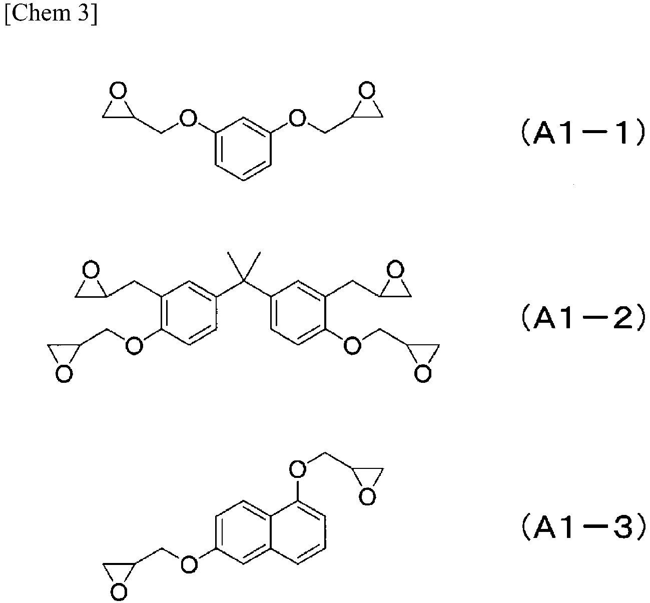

In the negative photosensitive resin composition of the present invention, it is preferable that the Component (A1) contains a liquid polyfunctional aromatic glycidyl ether having a viscosity at 25°C of 10,000 to 150,000 mPa·s. When the Component (A1) contains a liquid polyfunctional aromatic glycidyl ether having a viscosity at 25°C of 10,000 mPa·s or more, the degree of cationic polymerization reaction of the total Component (A) during pattern processing is further lowered, and the resin composition becomes flexible, which is preferable in that adhesion is further improved. Moreover, when the Component (A1) contains a liquid polyfunctional aromatic glycidyl ether having a viscosity at 25°C of 150,000 mPa·s or less, compatibility of the negative photosensitive resin composition is improved, which is preferable in that resolution is improved. As the liquid polyfunctional aromatic glycidyl ether having a viscosity at 25°C of 10,000 to 150,000 mPa·s, for example, compounds represented by the chemical formulas (A1-2) and (A1-3) and the like can be used. The content of the liquid polyfunctional aromatic glycidyl ether having a viscosity at 25°C of 10,000 to 150,000 mPa·s in the Component (A1) is preferably 50 to 100% by weight, more preferably 60 to 100% by weight, and even more preferably 80 to 100% by weight from the viewpoint of improving adhesion.

The negative photosensitive resin composition of the present invention can contain a cationic polymerizable compound other than the Component (A1) as the Component (A). Preferred examples of such Component (A) include epoxy compounds, oxetane compounds, ethylenically unsaturated compounds (such as vinyl ethers and styrenes), bicyclo-orthoesters, spiro-orthocarbonates, and spiro-orthoesters, which are not included in the Component (A1).

As the epoxy compound, known ones can be used, and preferred examples thereof include aromatic epoxy compounds, alicyclic epoxy compounds, and aliphatic epoxy compounds.

Preferred examples of the aromatic epoxy compound include glycidyl ethers of monovalent or polyvalent phenols (phenol, bisphenol A, phenol novolac, and compounds obtained by adding alkylene oxide thereto) having at least one aromatic ring.

Preferred examples of the alicyclic epoxy compound include compounds obtained by epoxidizing a compound having at least one cyclohexene ring or cyclopentene ring with an oxidizing agent (such as 3,4-epoxycyclohexylmethyl-3,4-epoxycyclohexanecarboxylate).

Preferred examples of the aliphatic epoxy compound include polyglycidyl ethers of aliphatic polyhydric alcohols or alkylene oxide adducts thereof (such as 1,4-butanediol diglycidyl ether and 1,6-hexanediol diglycidyl ether), polyglycidyl esters of aliphatic polybasic acids (such as diglycidyl tetrahydrophthalate), and epoxy compounds of long-chain unsaturated compounds (such as epoxidized soybean oil and epoxidized polybutadiene).

As the oxetane compound, known ones can be used, and preferred examples thereof include 3-ethyl-3-hydroxymethyloxetane, 2-ethylhexyl (3-ethyl-3-oxetanylmethyl) ether, 2-hydroxyethyl (3-ethyl-3-oxetanylmethyl) ether, 2-hydroxypropyl (3-ethyl-3-oxetanylmethyl) ether, 1,4-bis[(3-ethyl-3-oxetanylmethoxy)methyl]benzene, oxetanylsilsesquioxetane, and phenol novolac oxetane.

As the ethylenically unsaturated compound, known cationic polymerizable monomers can be used, and preferred examples thereof include aliphatic monovinyl ethers, aromatic monovinyl ethers, polyfunctional vinyl ethers, styrenes, and cationic polymerizable nitrogen-containing monomers.

Preferred examples of the aliphatic monovinyl ether include methyl vinyl ether, ethyl vinyl ether, butyl vinyl ether, and cyclohexyl vinyl ether.

Preferred examples of the aromatic monovinyl ether include 2-phenoxyethyl vinyl ether, phenyl vinyl ether, and p-methoxyphenyl vinyl ether.

Preferred examples of the polyfunctional vinyl ether include butanediol-1,4-divinyl ether and triethylene glycol divinyl ether.

Preferred examples of the styrenes include styrene, α-methylstyrene, p-methoxystyrene, and p-tert-butoxystyrene.

Preferred examples of the cationic polymerizable nitrogen-containing monomer include N-vinylcarbazole and N-vinylpyrrolidone.

Preferred examples of the bicyclo-orthoester include 1-phenyl-4-ethyl-2,6,7-trioxabicyclo[2.2.2]octane and 1-ethyl-4-hydroxymethyl-2,6,7-trioxabicyclo-[2.2.2]octane.

Preferred examples of the spiro-orthocarbonate include 1,5,7,11-tetraoxaspiro[5.5]undecane and 3,9-dibenzyl-1,5,7,11-tetraoxaspiro[5.5]undecane.

Preferred examples of the spiro-orthoester include 1,4,6-trioxaspiro[4.4]nonane, 2-methyl-1,4,6-trioxaspiro[4.4]nonane, and 1,4,6-trioxaspiro[4.5]decane.

Among these cationic polymerizable compounds, compounds selected from epoxy compounds, oxetane compounds, and vinyl ethers are preferred, and compounds selected from epoxy compounds and oxetane compounds are more preferred.

By including an epoxy compound having an isocyanurate skeleton as the Component (A), the dielectric constant and dielectric loss tangent of a cured film obtained by curing the resin composition can be kept low while maintaining cationic polymerizability, which is preferable. The epoxy compound having an isocyanurate skeleton itself does not dissolve in an alkaline aqueous solution, but when development is performed with an alkaline aqueous solution, pattern processing with the alkaline aqueous solution is possible without hindering the alkali solubility of the resin composition. Although the reason is not clear, it is thought to be because it is compatible with Component (C), which is alkali-soluble and described later.

The Component (A) preferably contains a cationic polymerizable compound selected from compounds represented by the following general formulas (1) and (2).

As the Component (A), an epoxy compound represented by general formula (1) is particularly preferred from the viewpoints of alkali solubility and photoreactivity during pattern processing.

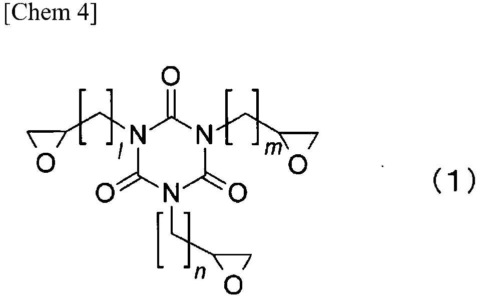

In general formula (1), l, m, and n are each independently an integer of 1 to 6.

Preferred examples of the epoxy compound represented by general formula (1) include TEPIC (registered trademark)-S, TEPIC (registered trademark)-L, TEPIC (registered trademark)-VL, TEPIC (registered trademark)-PASB26L, TEPIC (registered trademark)-PASB22, TEPIC (registered trademark)-FL, and TEPIC (registered trademark)-UC (trade names, all manufactured by Nissan Chemical Corporation), which are triglycidyl isocyanurates. Preferred examples of the epoxy compound represented by general formula (1) include TEPIC (registered trademark)-S, TEPIC (registered trademark)-L, TEPIC (registered trademark)-VL, and TEPIC (registered trademark)-FL (trade names, all manufactured by Nissan Chemical Corporation).

It is preferable that the Component (A) contains an epoxy compound represented by general formula (2) from the viewpoints of resolution during pattern processing and photoreactivity.

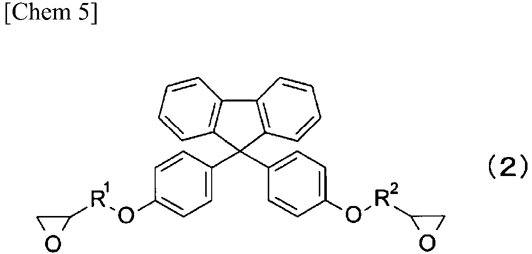

In general formula (2), R¹ and R² are each independently a divalent organic group.

Preferred examples of the epoxy compound represented by general formula (2) include OGSOL (registered trademark) PG-100, OGSOL (registered trademark) CG-500, OGSOL (registered trademark) EG-200, and OGSOL (registered trademark) EG-280 (trade names, all manufactured by Osaka Gas Chemicals Co., Ltd.), and OGSOL (registered trademark) EG-200 and OGSOL (registered trademark) EG-280 (trade names, both manufactured by Osaka Gas Chemicals Co., Ltd.) are particularly preferred from the viewpoint of compatibility.

The (A) cationic polymerizable compound may be used alone, or two or more kinds thereof may be used in combination.

Moreover, in the negative photosensitive resin composition of the present invention, the content of the Component (A) in the total negative photosensitive resin composition is preferably 45 to 70% by mass. The lower limit of the content is more preferably 50% by mass or more. The upper limit of the content is more preferably 60% by mass or less. When the content of the Component (A) is the lower limit of the preferred range or more, the contrast in the dissolution rate of the exposed area and the unexposed area in a developer during pattern formation becomes large, which is preferable in that resolution is improved. When the content of the Component (A) is the upper limit of the preferred range or less, it is preferable from the viewpoint that when the negative photosensitive resin composition is made into a film, that is, a resin composition coating film, the surface of the resin composition coating film is tack-free and handling becomes easy, and from the viewpoint that the solubility in a developer increases and resolution is improved.

In the present invention, the content of the Component (A) in the total negative photosensitive resin composition refers to the content ratio of the Component (A) when the total of all components excluding the solvent is 100% by mass. The same applies to the content of other components.

### <Component (B)>

The negative photosensitive resin composition of the present invention contains a photocationic polymerization initiator as Component (B) (hereinafter sometimes referred to as "(B) photocationic polymerization initiator"). Component (B) generates an acid by light to cause cationic polymerization.

As Component (B), known compounds can be used, but it is preferable that Component (B) contains a sulfonium salt, and contains at least one selected from the group consisting of a borate ion, a phosphate ion, and a gallate ion as a counteranion forming the sulfonium salt. Since Component (B) contains such a compound, cationic polymerization of Component (A) proceeds sufficiently during pattern processing, which is preferable in that a good pattern can be obtained.

Preferred examples of the cation forming the sulfonium salt include, but are not limited to: triarylsulfoniums such as triphenylsulfonium, tri-p-tolylsulfonium, tris(4-methoxyphenyl)sulfonium, 1-naphthyldiphenylsulfonium, 2-naphthyldiphenylsulfonium, tris(4-fluorophenyl)sulfonium, tri-1-naphthylsulfonium, tri-2-naphthylsulfonium, tris(4-hydroxyphenyl)sulfonium, 4-(phenylthio)phenyldiphenylsulfonium, 4-(p-tolylthio)phenyldi-p-tolylsulfonium, 4-(4-methoxyphenylthio)phenylbis(4-methoxyphenyl)sulfonium, 4-(phenylthio)phenylbis(4-fluorophenyl)sulfonium, 4-(phenylthio)phenylbis(4-methoxyphenyl)sulfonium, 4-(phenylthio)phenyldi-p-tolylsulfonium, [4-(4-biphenylylthio)phenyl]-4-biphenylylphenylsulfonium, [4-(2-thioxanthonylthio)phenyl]diphenylsulfonium, bis[4-(diphenylsulfonio)phenyl] sulfide, bis {4-[bis[4-(2-hydroxyethoxy)phenyl]sulfonio]phenyl} sulfide, bis{4-[bis(4-fluorophenyl)sulfonio]phenyl} sulfide, bis{4-[bis(4-methylphenyl)sulfonio]phenyl} sulfide, bis{4-[bis(4-methoxyphenyl)sulfonio]phenyl} sulfide, 4-(4-benzoyl-2-chlorophenylthio)phenylbis(4-fluorophenyl)sulfonium, 4-(4-benzoyl-2-chlorophenylthio)phenyldiphenylsulfonium, 4-(4-benzoylphenylthio)phenylbis(4-fluorophenyl)sulfonium, 4-(4-benzoylphenylthio)phenyldiphenylsulfonium, 7-isopropyl-9-oxo-10-thia-9,10-dihydroanthracen-2-yldi-p-tolylsulfonium, 7-isopropyl-9-oxo-10-thia-9,10-dihydroanthracen-2-yldiphenylsulfonium, 2-[(di-p-tolyl)sulfonio]thioxanthone, 2-[(diphenyl)sulfonio]thioxanthone, 4-(9-oxo-9H-thioxanthen-2-yl)thiophenyl-9-oxo-9H-thioxanthen-2-ylphenylsulfonium, 4-[4-(4-tert-butylbenzoyl)phenylthio]phenyldi-p-tolylsulfonium, 4-[4-(4-tert-butylbenzoyl)phenylthio]phenyldiphenylsulfonium, 4-[4-(benzoylphenylthio)]phenyldi-p-tolylsulfonium, 4-[4-(benzoylphenylthio)]phenyldiphenylsulfonium, 5-(4-methoxyphenyl)thianthrenium, 5-phenylthianthrenium, 5-tolylthianthrenium, 5-(4-ethoxyphenyl)thianthrenium, and 5-(2,4,6-trimethylphenyl)thianthrenium; diarylsulfoniums such as diphenylphenacylsulfonium, diphenyl-4-nitrophenacylsulfonium, diphenylbenzylsulfonium, and diphenylmethylsulfonium; monoarylsulfoniums such as phenylmethylbenzylsulfonium, 4-hydroxyphenylmethylbenzylsulfonium, 4-methoxyphenylmethylbenzylsulfonium, 4-acetocarbonyloxyphenylmethylbenzylsulfonium, 4-hydroxyphenyl(2-naphthylmethyl)methylsulfonium, 2-naphthylmethylbenzylsulfonium, 2-naphthylmethyl(1-ethoxycarbonyl)ethylsulfonium, phenylmethylphenacylsulfonium, 4-hydroxyphenylmethylphenacylsulfonium, 4-methoxyphenylmethylphenacylsulfonium, 4-acetocarbonyloxyphenylmethylphenacylsulfonium, 2-naphthylmethylphenacylsulfonium, 2-naphthyloctadecylphenacylsulfonium, and 9-anthracenylmethylphenacylsulfonium; and dimethylphenacylsulfonium, phenacyltetrahydrothiophenium, dimethylbenzylsulfonium, benzyltetrahydrothiophenium, and octadecylmethylphenacylsulfonium.

When the photocationic polymerization initiator as Component (B) contains a sulfonium salt, preferred examples of counteranions forming the sulfonium salt include borate ions, phosphate ions, gallate ions, and the like. Here, a borate ion is a complex ion having boron as a central atom, a phosphate ion is a complex ion having phosphorus as a central atom, and a gallate ion is a complex ion having gallium as a central atom.

Preferred examples of borate ions include, but are not limited to, pentafluorophenylborate, trifluorophenylborate, tetrafluorophenylborate, trifluoromethylphenylborate, bis(trifluoromethyl)phenylborate, pentafluoroethylphenylborate, bis(pentafluoroethyl)phenylborate, fluoro-bis(trifluoromethyl)phenylborate, fluoro-pentafluoroethylphenylborate, and fluoro-bis(pentafluoroethyl)phenylborate.

Preferred examples of phosphate ions include, but are not limited to, hexafluorophosphate and tris(pentafluoroethyl)trifluorophosphate.

Preferred examples of gallate ions include, but are not limited to, tetrakis(pentafluorophenyl)gallate and tetrakis(3,5-bis(trifluoromethyl)phenyl)gallate.

The content of Component (B) is preferably 0.1% by mass or more, and more preferably 0.5% by mass or more, when the entire resin composition is 100% by mass. This allows the cationic polymerizable compound to exhibit sufficient curability and can improve pattern processability. On the other hand, from the viewpoint of improving the storage stability of the resin composition, the content of Component (B) is preferably 10% by mass or less, and more preferably 8% by mass or less.

### <Component (C)>

The negative photosensitive resin composition of the present invention preferably contains, as Component (C), at least one polymer compound selected from polyamide, polyimide, and polyamide-imide. In the present invention, a polyimide precursor and a polybenzoxazole precursor respectively correspond to the above-mentioned polyamide.

The resin composition of the present invention is preferable because, by containing Component (C), it exhibits excellent film-forming properties when making the resin composition into a film-like resin composition coating film, and exhibits excellent tensile strength and tensile elongation when made into a cured film. Furthermore, containing Component (C) is preferable in that the reactivity of the (A) cationic polymerizable compound is moderately suppressed by functional groups such as imide groups and amide groups, thereby improving adhesiveness when bonded to a substrate. Component (C) may be used alone or in combination of two or more types.

The weight average molecular weight of Component (C) is not particularly limited, but the weight average molecular weight is preferably 1,000 or more and 200,000 or less. The weight average molecular weight of Component (C) in the present invention is determined by measuring via a gel permeation chromatography method (GPC method) and calculating in terms of polystyrene.

Component (C) is preferably alkali-soluble. Being alkali-soluble is preferable because development during pattern processing can be performed with an aqueous alkaline solution without using organic solvents that cause environmental impact. The term "alkali-soluble" as used herein refers to a substance that dissolves in an amount of 0.1 g or more in 100 g of a 2.38% by mass aqueous tetramethylammonium hydroxide solution at 25°C.

In order to exhibit alkali solubility, Component (C) desirably has an alkali-soluble functional group. The alkali-soluble functional group is an acidic functional group, and specific examples thereof include a phenolic hydroxyl group, a carboxyl group, and a sulfonic acid group. Among the above alkali-soluble functional groups, the alkali-soluble functional group is preferably a phenolic hydroxyl group from the viewpoint of problems such as storage stability of the resin composition and corrosion of copper wiring, which is a conductor. That is, Component (C) is preferably a compound having a phenolic hydroxyl group in the molecular chain.

Furthermore, in the resin composition of the present invention, the molecular chain terminal of Component (C) preferably has a structure derived from a carboxylic acid residue. However, it is also possible to include a polymer compound whose molecular chain terminal does not have a structure derived from a carboxylic acid residue.

In the resin composition of the present invention, when a polymer compound whose molecular chain terminal does not have a structure derived from a carboxylic acid residue is included, its content is preferably as small as possible. Specifically, relative to 100 parts by mass in total of the Component (C) having a structure derived from a carboxylic acid residue at the molecular chain terminal, the content of the Component (C) not having a structure derived from a carboxylic acid residue at the molecular chain terminal is preferably 0 parts by mass or more and 10 parts by mass or less, more preferably 0 parts by mass or more and 5 parts by mass or less, and particularly preferably 0 parts by mass or more and 2 parts by mass or less.

The content of Component (C) is not particularly limited, but is preferably 20% by mass or more and 95% by mass or less when the entire resin composition is 100% by mass. The lower limit of the content is more preferably 30% by mass or more. The upper limit of the content is more preferably 85% by mass or less, and particularly preferably 70% by mass or less. By containing 20% by mass or more of Component (C) in the resin composition, the film strength when the resin composition is made into a cured film is improved. On the other hand, by setting the content of Component (C) in the resin composition to 95% by mass or less, the cationic polymerization reaction proceeds easily, and the chemical resistance of the cured film is improved.

By having a structure derived from a carboxylic acid residue at the molecular chain terminal of Component (C), the molecular structure can be made such that the molecular chain terminal does not possess an amine terminal structure that can serve as an inhibitory functional group for cationic polymerization. As a result, even when polyamide, polyimide, and polyamide-imide are used, sufficient cationic polymerizability can be exhibited, which is preferable.

Here, the structure derived from a carboxylic acid residue at the molecular chain terminal of Component (C) refers to an organic group derived from a carboxylic acid residue that can constitute polyamide, polyimide, or polyamide-imide, and refers to a structure derived from a monocarboxylic acid, a dicarboxylic acid, a monoacid chloride compound, a diacid chloride compound, a tetracarboxylic acid or an acid anhydride, an acid dianhydride, or the like. Among the above, it is particularly preferable that the structure derived from the carboxylic acid residue at the molecular chain terminal of Component (C) is a structure derived from a tetracarboxylic dianhydride.

A structure derived from a tetracarboxylic dianhydride at the molecular chain terminal is preferable in that the storage stability of the resin composition before thermal curing is improved. Furthermore, it is preferable in that, when the resin composition is made into a cured film, the terminal carboxylic acid anhydride group becomes a reactive functional group, and the heat resistance and chemical resistance after thermal curing are improved.

Examples of the structure derived from a carboxylic acid residue at the molecular chain terminal of Component (C) include, but are not limited to, structures derived from aromatic dicarboxylic acids, aromatic acid dianhydrides, alicyclic dicarboxylic acids, alicyclic acid dianhydrides, aliphatic dicarboxylic acids, aliphatic acid dianhydrides, and the like. These may be used alone or in combination of two or more types.

Among these, an organic group derived from an alicyclic dicarboxylic acid residue is preferable because a transparent resin can be designed for the wavelength used during patterning, and as a result, fine pattern processability can be exhibited in a thick film.

In the present invention, Component (C) is preferably at least one polymer compound selected from polyamide, polyimide, and polyamide-imide, but more preferably a compound having at least one or more types of structures selected from structures represented by the following general formula (8) and general formula (9).

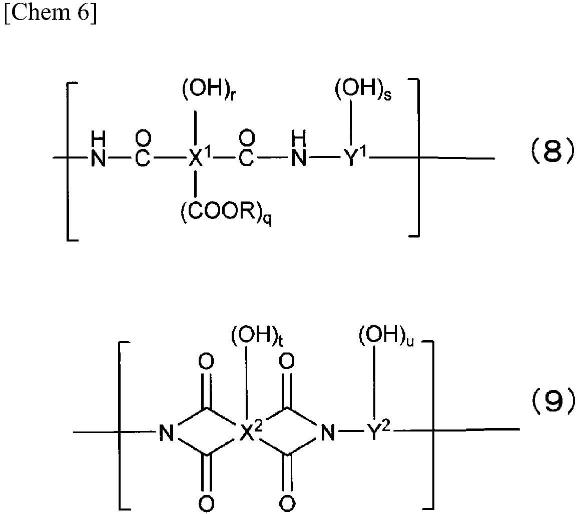

In general formulas (8) and (9), X¹ represents a 2- to 8-valent organic group, X² represents a 4- to 8-valent organic group, Y¹ and Y² each independently represent a 2- to 6-valent organic group, and R represents a hydrogen atom or an organic group having 1 to 20 carbon atoms. q is an integer of 0 to 2, and r, s, t, and u are each independently an integer of 0 to 4.

Y¹ and Y² in the general formulas (8) and (9) are diamine residues, and preferably contain a diamine residue having a phenolic hydroxyl group or a carboxyl group. By containing a diamine residue having a phenolic hydroxyl group or a carboxyl group, moderate solubility of Component (C) in an alkaline developer is obtained, so that high contrast between exposed parts and unexposed parts is obtained, and a desired pattern can be formed.

Specific examples of diamines having a phenolic hydroxyl group include, for example, aromatic diamines such as bis(3-amino-4-hydroxyphenyl)hexafluoropropane, bis(3-amino-4-hydroxyphenyl)sulfone, bis(3-amino-4-hydroxyphenyl)propane, bis(3-amino-4-hydroxyphenyl)methylene, bis(3-amino-4-hydroxyphenyl)ether, bis(3-amino-4-hydroxy)biphenyl, 2,2'-ditrifluoromethyl-5,5'-dihydroxyl-4,4'-diaminobiphenyl, bis(3-amino-4-hydroxyphenyl)fluorene, and 2,2'-bis(trifluoromethyl)-5,5'-dihydroxybenzidine; compounds in which a part of the hydrogen atoms of these aromatic rings or hydrocarbons is substituted with an alkyl group or fluoroalkyl group having 1 to 10 carbon atoms, a halogen atom, or the like; and diamines having structures shown below, but are not limited to these. Other diamines to be copolymerized can be used as they are, or as corresponding diisocyanate compounds or trimethylsilylated diamines. Moreover, two or more of these diamine components may be used in combination.

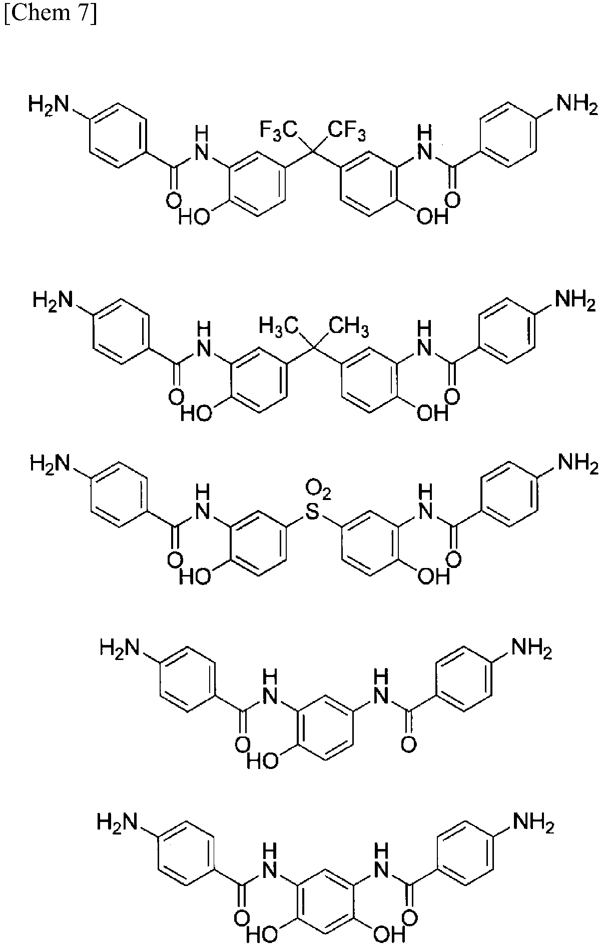

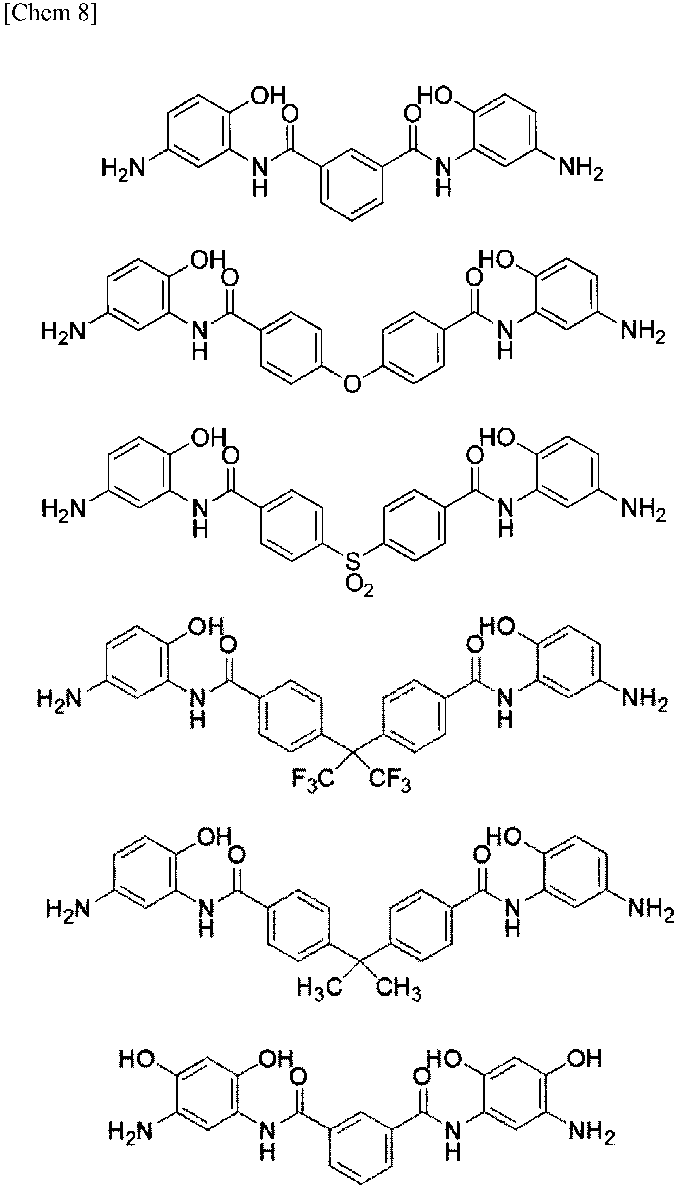

Furthermore, Component (C) preferably contains a diamine residue derived from any of the diamines represented by general formulas (3) to (7) from the viewpoint of pattern processability and adhesiveness. Among these, containing a diamine residue derived from the diamine represented by general formula (5) is particularly preferable because the photoreactivity of Component (A) is moderately suppressed and adhesiveness is improved.

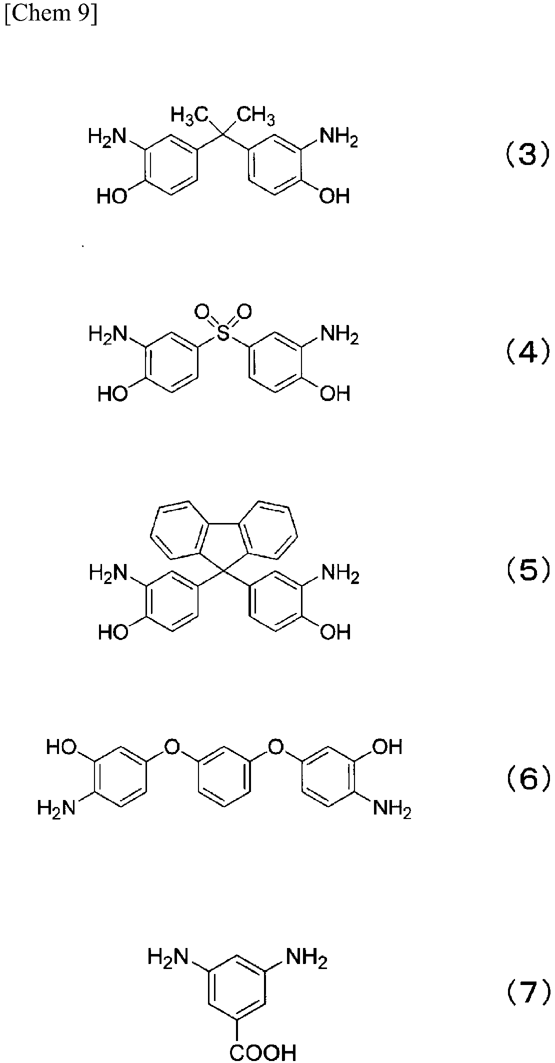

Y¹ and Y² in the general formulas (8) and (9) may contain a diamine residue having an aromatic group other than those described above. By copolymerizing these, heat resistance can be improved. Specific examples of the diamine having an aromatic group other than those described above include, but are not limited to: aromatic diamines such as 3,4'-diaminodiphenyl ether, 4,4'-diaminodiphenyl ether, 3,4'-diaminodiphenylmethane, 4,4'-diaminodiphenylmethane, 3,4'-diaminodiphenyl sulfone, 4,4'-diaminodiphenyl sulfone, 3,4'-diaminodiphenyl sulfide, 4,4'-diaminodiphenyl sulfide, 1,4-bis(4-aminophenoxy)benzene, benzidine, m-phenylenediamine, p-phenylenediamine, 1,5-naphthalenediamine, 2,6-naphthalenediamine, bis(4-aminophenoxyphenyl) sulfone, bis(3-aminophenoxyphenyl) sulfone, bis(4-aminophenoxy)biphenyl, bis{4-(4-aminophenoxy)phenyl}ether, 1,4-bis(4-aminophenoxy)benzene, 2,2'-dimethyl-4,4'-diaminobiphenyl, 2,2'-diethyl-4,4'-diaminobiphenyl, 3,3'-dimethyl-4,4'-diaminobiphenyl, 3,3'-diethyl-4,4'-diaminobiphenyl, 2,2',3,3'-tetramethyl-4,4'-diaminobiphenyl, 3,3',4,4'-tetramethyl-4,4'-diaminobiphenyl, and 2,2'-bis(trifluoromethyl)-4,4'-diaminobiphenyl; and compounds in which a part of the hydrogen atoms of the aromatic rings or hydrocarbons of these aromatic diamines are substituted with an alkyl group having 1 to 10 carbon atoms, a fluoroalkyl group, a halogen atom, or the like. Other diamines to be copolymerized can be used as they are, or as corresponding diisocyanate compounds or trimethylsilylated diamines. Furthermore, two or more of these diamine components may be used in combination.

In general formula (8) and general formula (9) in the present invention, X¹ and X² are carboxylic acid residues.

The carboxylic acid residue preferably has a structure derived from alicyclic tetracarboxylic dianhydride. That is, it is preferred that the component (C) is at least one compound selected from the group consisting of polyamide, polyimide, and polyamide-imide, and further has a structure derived from alicyclic tetracarboxylic dianhydride.

By the carboxylic acid residue having a structure derived from alicyclic tetracarboxylic dianhydride, the light transmittance of the resin composition with respect to the exposure wavelength becomes high, and processing in a thick film of 20 µm or more becomes easy. Furthermore, although the reason is not clear, it is preferable in that since the component (C) has a structure derived from alicyclic tetracarboxylic dianhydride, the reactivity of cationic polymerization becomes higher compared with aromatic acid dianhydride, and the chemical resistance of the film when the resin composition is made into a cured film is improved.

Among alicyclic tetracarboxylic dianhydrides, alicyclic tetracarboxylic dianhydrides having a polycyclic structure are preferred from the viewpoint that chemical resistance when made into a cured product is improved and ion migration resistance is improved. As the alicyclic tetracarboxylic dianhydride having a polycyclic structure, a compound represented by at least one of the following general formulas (10) and (11) is preferred.

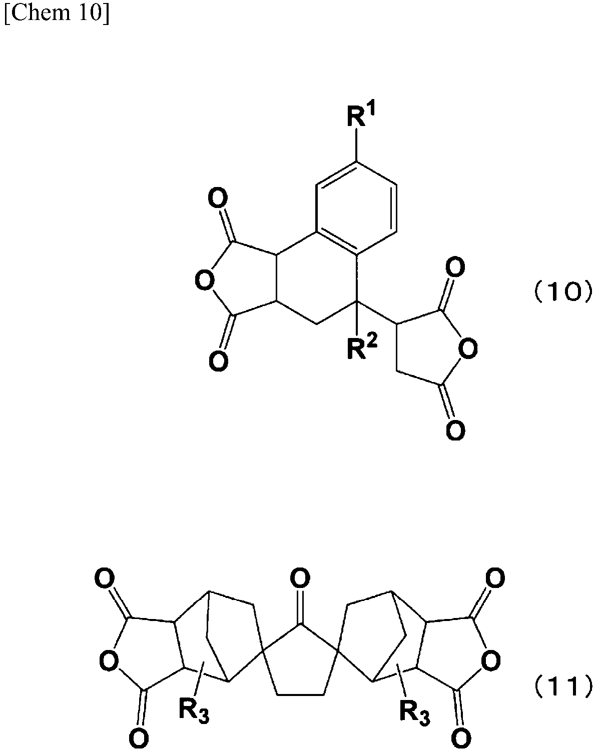

In the formulas, R¹, R², and R³ each independently represent a hydrogen atom or a methyl group.

Since the resin skeleton has flexibility by the component (C) having a structure derived from the compound represented by the general formula (10) or (11), it is preferable from the viewpoint that the solubility of the resin composition before curing in an organic solvent becomes high, the precipitation of the resin hardly occurs in the resin composition, and the storage stability is excellent.

Specific examples of the alicyclic tetracarboxylic dianhydride having a polycyclic structure include: 4-(2,5-dioxotetrahydrofuran-3-yl)-1,2,3,4-tetrahydronaphthalene-1,2-dicarboxylic dianhydride, 4-(2,5-dioxotetrahydrofuran-3-yl)-4-methyl-1,2,3,4-tetrahydronaphthalene-1,2-dicarboxylic dianhydride, 4-(2,5-dioxotetrahydrofuran-3-yl)-7-methyl-1,2,3,4-tetrahydronaphthalene-1,2-dicarboxylic dianhydride, norbornane-2-spiro-2'-cyclopentanone-5'-spiro-2"-norbornane-5,5",6,6"-tetracarboxylic dianhydride, and norbornane-2-spiro-2'-cyclohexanone-6'-spiro-2"-norbornane-5,5",6,6"-tetracarboxylic dianhydride.

The carboxylic acid residue may include a residue of an acid dianhydride other than the alicyclic tetracarboxylic dianhydride having the polycyclic structure. Specific examples of such an acid dianhydride include pyromellitic dianhydride, 3,3',4,4'-biphenyltetracarboxylic dianhydride, 2,3,3',4'-biphenyltetracarboxylic dianhydride, 2,2',3,3'-biphenyltetracarboxylic dianhydride, 3,3',4,4'-benzophenonetetracarboxylic dianhydride, 2,2',3,3'-benzophenonetetracarboxylic dianhydride, 2,2-bis(3,4-dicarboxyphenyl)propane dianhydride, 2,2-bis(2,3-dicarboxyphenyl)propane dianhydride, 1,1-bis(3,4-dicarboxyphenyl)ethane dianhydride, 1,1-bis(2,3-dicarboxyphenyl)ethane dianhydride, bis(3,4-dicarboxyphenyl)methane dianhydride, bis(2,3-dicarboxyphenyl)methane dianhydride, bis(3,4-dicarboxyphenyl)sulfone dianhydride, bis(3,4-dicarboxyphenyl)ether dianhydride, 1,2,5,6-naphthalenetetracarboxylic dianhydride, 9,9-bis(3,4-dicarboxyphenyl)fluorene dianhydride, 9,9-bis{4-(3,4-dicarboxyphenoxy)phenyl} fluorene dianhydride, 2,3,6,7-naphthalenetetracarboxylic dianhydride, 2,3,5,6-pyridinetetracarboxylic dianhydride, 3,4,9,10-perylenetetracarboxylic dianhydride, aromatic tetracarboxylic dianhydrides such as 2,2-bis(3,4-dicarboxyphenyl)hexafluoropropane dianhydride, 3,3',4,4'-diphenylsulfonetetracarboxylic dianhydride, 1,2,3,4-cyclobutanetetracarboxylic dianhydride, 1,2,3,4-cyclopentanetetracarboxylic dianhydride, 1,2,4,5-cyclohexanetetracarboxylic dianhydride, 5-(2,5-dioxotetrahydrofuryl)-3-methyl-3-cyclohexene-1,2-dicarboxylic dianhydride, 2,3,5-tricarboxy-2-cyclopentaneacetic dianhydride, and 2,3,4,5-tetrahydrofurantetracarboxylic dianhydride, but are not limited thereto. These are used alone or in combination of two or more kinds.

The molar ratio of each structure constituting the compounds represented by general formulas (8) and (9) can be confirmed by a method of calculating from the molar ratio of monomers used during polymerization, or a method of detecting peaks of a polyamide structure, an imide precursor structure, or an imide structure in the obtained resin, resin composition, or cured film using a nuclear magnetic resonance (NMR) apparatus.

The component (C), in which a molecular chain terminal is a structure derived from a carboxylic acid residue, can be obtained, for example, in the case of a polyimide having a carboxylic acid residue at a molecular chain terminal, by increasing the content of an acid anhydride relative to a diamine used during polymerization.

In this case, when the total of the carboxylic acid residues in the component (C) is taken as 100 mol%, the total of the amine residues is preferably 60 mol% or more and 98 mol% or less. That is, the component (C) is preferably a compound obtained by polymerization in which, when the total amount of carboxylic acid residues is taken as 100 mol%, the total of amine residues is 60 mol% or more and 98 mol% or less. When the total amount of amine residues is 60 mol% or more, the weight average molecular weight of the polymer compound tends to be 1,000 or more, and the film-forming property when making the resin composition into a film is excellent, and when it is 98 mol% or less, the content of a polymer compounds having amine residues at the terminals decreases, cationic polymerization reaction proceeds more easily, and the resolution is improved.

As another method for obtaining the component (C) in which a molecular chain terminal is a structure derived from a carboxylic acid residue, it can also be obtained by using a specific compound among compounds generally used as an end-capping agent, specifically, an acid anhydride, a monocarboxylic acid, a monoacid chloride compound, or a monoactive ester compound.

Further, by capping the molecular chain terminal of the component (C) with an end-capping agent of a carboxylic acid or an acid anhydride having a hydroxyl group, a carboxyl group, a sulfonic acid group, a thiol group, a vinyl group, an ethynyl group, or an allyl group, the dissolution rate of the component (C) in an aqueous alkaline solution and the mechanical properties of the resulting cured film can be easily adjusted to preferred ranges. In addition, a plurality of different terminal groups may be introduced by reacting a plurality of end-capping agents.

As the acid anhydride, monocarboxylic acid, monoacid chloride compound, and mono-active ester compound as the end-capping agent, acid anhydrides such as phthalic anhydride, maleic anhydride, nadic anhydride, cyclohexanedicarboxylic anhydride, and 3-hydroxyphthalic anhydride; monocarboxylic acids such as 3-carboxyphenol, 4-carboxyphenol, 3-carboxythiophenol, 4-carboxythiophenol, 1-hydroxy-7-carboxynaphthalene, 1-hydroxy-6-carboxynaphthalene, 1-hydroxy-5-carboxynaphthalene, 1-mercapto-7-carboxynaphthalene, 1-mercapto-6-carboxynaphthalene, 1-mercapto-5-carboxynaphthalene, 3-carboxybenzenesulfonic acid, and 4-carboxybenzenesulfonic acid, and monoacid chloride compounds in which the carboxyl group of these is converted into an acid chloride; monoacid chloride compounds in which only one carboxyl group of dicarboxylic acids such as terephthalic acid, phthalic acid, maleic acid, cyclohexanedicarboxylic acid, 1,5-dicarboxynaphthalene, 1,6-dicarboxynaphthalene, 1,7-dicarboxynaphthalene, and 2,6-dicarboxynaphthalene is converted into an acid chloride; and active ester compounds obtained by a reaction between a monoacid chloride compound and N-hydroxybenzotriazole, imidazole, or N-hydroxy-5-norbornene-2,3-dicarboxyimide are preferred. Two or more kinds of these may be used.

The polymer compound into which these end-capping agents are introduced becomes the component (C), which is a structure in which a molecular chain terminal is derived from a carboxylic acid residue. The structure derived from the end-capping agent in the component (C) can be easily detected by the following method. For example, by dissolving the component (C) into which the end-capping agent has been introduced in an acidic solution to decompose it into an amine component and an acid anhydride component which are constitutional units, it is possible to easily detect what kind of end-capping agent was used by gas chromatography (GC) or NMR. Apart from this, it can also be easily detected by directly measuring the resin component into which the end-capping agent has been introduced by pyrolysis gas chromatography (PGC), an infrared spectrum, and a ¹³C-NMR spectrum.

In the present invention, the component (C) is synthesized, for example, by the following method, but is not limited thereto.

The polyimide is synthesized by a known method by replacing a part of the diamine with a primary monoamine which is an end-capping agent, or by replacing the tetracarboxylic dianhydride with a dicarboxylic anhydride which is an end-capping agent. For example, a polyimide precursor is obtained by using a method such as a method of reacting a tetracarboxylic dianhydride, a diamine compound, and a monoamine at a low temperature, a method of reacting a tetracarboxylic dianhydride, a dicarboxylic anhydride, and a diamine compound at a low temperature, or a method of obtaining a diester from a tetracarboxylic dianhydride and an alcohol and then reacting the diester with a diamine and a monoamine in the presence of a condensing agent. Thereafter, the polyimide can be synthesized using a known imidization reaction method.

In the present invention, it is preferred that after the component (C) is polymerized by the above method, the reaction mixture is poured into a large amount of water or a mixed liquid of methanol and water or the like to precipitate the component (C), which is then filtered, dried, and isolated. The drying temperature is preferably 40 to 100°C, and more preferably 50 to 80°C. By this operation, unreacted monomers and oligomer components such as dimers and trimers are removed, and the film properties after thermal curing can be improved.

In the present invention, the imidization ratio can be easily determined, for example, by the following method. First, an infrared absorption spectrum of the polymer is measured to confirm the presence of absorption peaks of an imide structure derived from the polyimide (near 1780 cm⁻¹ and near 1377 cm⁻¹). Next, an infrared absorption spectrum is measured for a sample obtained by heat-treating the polymer at 350°C for 1 hour as a sample having an imidization ratio of 100%, and the imidization ratio is determined by comparing the peak intensities near 1377 cm⁻¹ of the polymer before and after the heat treatment. The imidization ratio is preferably 50% or more, and more preferably 80% or more, because a change in the ring-closure ratio during thermal curing is suppressed and an effect of reducing stress can be obtained.

### <Other components>

The negative photosensitive resin composition of the present invention may contain a sensitizer. The sensitizer is a compound capable of absorbing light, donating the absorbed light energy to the component (B), generating an acid, and causing cationic polymerization. In addition, since the sensitizer absorbs light of an irradiation wavelength during pattern processing, the transmittance of a negative photosensitive resin composition coating film formed from the negative photosensitive resin composition can be lowered. Therefore, by controlling the content of the sensitizer in the negative photosensitive resin composition, it is possible to arbitrarily control the transmittance of the negative photosensitive resin composition coating film obtained from the composition.

As the sensitizer, although not particularly limited, an anthracene compound is preferred, and for example, an anthracene compound having alkoxy groups at the 9-position and the 10-position (9,10-dialkoxy-anthracene derivative) is more preferred. As the alkoxy group, for example, C1 to C4 alkoxy groups such as a methoxy group, an ethoxy group, and a propoxy group are preferably mentioned. The 9,10-dialkoxy-anthracene derivative may further have a substituent. As the substituent, for example, halogen atoms such as a fluorine atom, a chlorine atom, a bromine atom, and an iodine atom, C1 to C4 alkyl groups such as a methyl group, an ethyl group, and a propyl group, a sulfonic acid alkyl ester group, and a carboxylic acid alkyl ester group are preferably mentioned. As the alkyl in the sulfonic acid alkyl ester group or the carboxylic acid alkyl ester group, for example, C1 to C4 alkyl such as methyl, ethyl, and propyl is preferably mentioned. The substitution position of these substituents is preferably the 2-position.

The content of the sensitizer is not particularly limited, but when the entire negative photosensitive resin composition is taken as 100% by mass, it is preferably 0.05% by mass or more, and more preferably 0.1% by mass or more. Thereby, the transmittance of the negative photosensitive resin composition coating film can be lowered, and even on a substrate with a rough surface such as ceramics, reflected light from the substrate surface can be suppressed, making it easy to process fine patterns. On the other hand, from the viewpoint of suppressing a decrease in mechanical properties or thermal properties of a cured film of the negative photosensitive resin composition coating film formed from the negative photosensitive resin composition, when the entire negative photosensitive resin composition is taken as 100% by mass, the content of the sensitizer is preferably 10% by mass or less, and more preferably 5% by mass or less.

The negative photosensitive resin composition of the present invention may contain a thermal crosslinking agent. As the thermal crosslinking agent, a compound having an alkoxymethyl group or a methylol group is preferred.

Examples of the compound having an alkoxymethyl group or a methylol group preferably include, for example, DML-PC, DML-PEP, DML-OC, DML-OEP, DML-34X, DML-PTBP, DML-PCHP, DML-OCHP, DML-PFP, DML-PSBP, DML-POP, DML-MBOC, DML-MBPC, DML-MTrisPC, DML-BisOC-Z, DML-BisOCHP-Z, DML-BPC, DML-BisOC-P, DMOM-PC, DMOM-PTBP, DMOM-MBPC, TriML-P, TriML-35XL, TML-HQ, TML-BP, TML-pp-BPF, TML-BPE, TML-BPA, TML-BPAF, TML-BPAP, TMOM-BP, TMOM-BPE, TMOM-BPA, TMOM-BPAF, TMOM-BPAP, HML-TPPHBA, HML-TPHAP, HMOM-TPPHBA, HMOM-TPHAP (the above are trade names, manufactured by Honshu Chemical Industry Co., Ltd.), NIKALAC (registered trademark) MX-290, NIKALAC MX-280, NIKALAC MW-100LM, and NIKALAC MX-750LM (the above are trade names, manufactured by Sanwa Chemical Co., Ltd.).

The negative photosensitive resin composition of the present invention can further contain a silane compound. By containing the silane compound, the adhesiveness of the negative photosensitive resin composition coating film, which will be described later, is improved. Specific examples of the silane compound preferably include: N-phenylaminoethyltrimethoxysilane, N-phenylaminoethyltriethoxysilane, N-phenylaminopropyltrimethoxysilane, N-phenylaminopropyltriethoxysilane, N-phenylaminobutyltrimethoxysilane, N-phenylaminobutyltriethoxysilane, vinyltrimethoxysilane, vinyltriethoxysilane, vinyltrichlorosilane, vinyltris(β-methoxyethoxy)silane, 3-methacryloxypropyltrimethoxysilane, 3-acryloxypropyltrimethoxysilane, p-styryltrimethoxysilane, 3-methacryloxypropylmethyldimethoxysilane, 3-methacryloxypropylmethyldiethoxysilane, and 2-(3,4-epoxycyclohexyl)ethyltrimethoxysilane, etc.

Further, the negative photosensitive resin composition of the present invention may contain, as necessary, a surfactant for the purpose of improving wettability with a support; esters such as ethyl lactate and propylene glycol monomethyl ether acetate; alcohols such as ethanol; ketones such as cyclohexanone and methyl isobutyl ketone; and ethers such as tetrahydrofuran and dioxane. Also, inorganic particles such as silicon dioxide and titanium dioxide, or polyimide powder, etc. may be contained for the purpose of suppressing the coefficient of thermal expansion, increasing the dielectric constant, or decreasing the dielectric constant.

### <Negative photosensitive resin composition coating film, negative photosensitive resin composition film>

The shape before curing of the negative photosensitive resin composition of the present invention is not limited, and for example, it may be in a varnish-like state or a film-like state. When the negative photosensitive resin composition of the present invention is in a varnish-like state, it is referred to as a negative photosensitive resin composition varnish. When the negative photosensitive resin composition of the present invention is in a film-like state, it is referred to as a negative photosensitive resin composition coating film. When the negative photosensitive resin composition of the present invention is in a varnish-like state, it can further contain an organic solvent in addition to the components (A) to (C) and other components added as necessary.

The negative photosensitive resin composition film of the present invention has the negative photosensitive resin composition coating film of the present invention and a support. The negative photosensitive resin composition film of the present invention is obtained by laminating the negative photosensitive resin composition of the present invention in a film form with a support. In addition, when the negative photosensitive resin composition of the present invention is in a varnish-like state, the negative photosensitive resin composition film of the present invention can be obtained by applying the negative photosensitive resin composition of the present invention onto a support, and then drying it if necessary.

The negative photosensitive resin composition coating film of the present invention preferably has a thickness of 5 µm or more from the viewpoint of handling properties. In addition, from the viewpoint that variation in film thickness can be suppressed, the thickness of the negative photosensitive resin composition coating film is preferably 100 µm or less, more preferably 80 µm or less, and particularly preferably 60 µm or less.

Next, a method for producing a negative photosensitive resin composition film using the negative photosensitive resin composition of the present invention will be described. The negative photosensitive resin composition film of the present invention is obtained by applying a varnish-like negative photosensitive resin composition onto a support, and then drying it if necessary. The negative photosensitive resin composition varnish is obtained by adding an organic solvent to the negative photosensitive resin composition. The organic solvent used here may be any solvent as long as it dissolves the negative photosensitive resin composition.

Specific examples of the organic solvent include: ethers such as ethylene glycol monomethyl ether, ethylene glycol monoethyl ether, propylene glycol monomethyl ether, propylene glycol monoethyl ether, ethylene glycol dimethyl ether, ethylene glycol diethyl ether, and ethylene glycol dibutyl ether; acetates such as ethylene glycol monoethyl ether acetate, propylene glycol monomethyl ether acetate, propyl acetate, butyl acetate, isobutyl acetate, 3-methoxybutyl acetate, 3-methyl-3-methoxybutyl acetate, methyl lactate, ethyl lactate, and butyl lactate; ketones such as acetone, methyl ethyl ketone, acetylacetone, methyl propyl ketone, methyl butyl ketone, methyl isobutyl ketone, cyclopentanone, and 2-heptanone; alcohols such as butyl alcohol, isobutyl alcohol, pentanol, 4-methyl-2-pentanol, 3-methyl-2-butanol, 3-methyl-3-methoxybutanol, and diacetone alcohol; aromatic hydrocarbons such as toluene and xylene; and others such as N-methyl-2-pyrrolidone, N-cyclohexyl-2-pyrrolidone, N,N-dimethylformamide, N,N-dimethylacetamide, dimethyl sulfoxide, γ-butyrolactone, etc. are preferably mentioned.

Further, the negative photosensitive resin composition varnish may be filtered using a filter paper or a filter. The filtration method is not particularly limited, but a method of performing pressure filtration using a filter having a retained particle size of 0.4 µm to 10 µm is preferred.

The negative photosensitive resin composition film of the present invention is used with a negative photosensitive resin composition coating film formed on a support. As the support, although not particularly limited, various commercially available films such as a polyethylene terephthalate (PET) film, a polyphenylene sulfide film, and a polyimide film can be used. A surface treatment using silicone, a silane coupling agent, an aluminum chelating agent, polyurea, or the like may be applied to a joint surface between the support and the negative photosensitive resin composition coating film in order to improve adhesiveness and releasability. In addition, although the thickness of the support is not particularly limited, it is preferably in a range of 10 to 100 µm from the viewpoint of workability.

The negative photosensitive resin composition film of the present invention may further have a protective film on the film surface in order to protect the surface. Thereby, the surface of the negative photosensitive resin composition film can be protected from pollutants such as dust and dirt in the atmosphere. Examples of the protective film include a polyolefin film and a polyester film. The protective film preferably has a small adhesive force with the negative photosensitive resin composition film.

Examples of a method for applying the negative photosensitive resin composition varnish onto a support include application using a spin coater, spray coating, roll coating, screen printing, a blade coater, a die coater, a calender coater, a meniscus coater, a bar coater, a roll coater, a comma roll coater, a gravure coater, a screen coater, a slit die coater, and the like. In addition, although the applied film thickness varies depending on the application method, the solid content concentration of the composition, the viscosity, and the like, usually, the film thickness after drying is preferably 0.5 µm or more and 100 µm or less.

For drying, an oven, a hot plate, infrared rays, or the like can be used. The drying temperature and drying time may be in a range in which the organic solvent can be volatilized, and it is preferable to appropriately set a range such that the negative photosensitive resin composition film is in an uncured or semi-cured state. Specifically, it is preferably performed in a range of 40°C to 120°C for 1 minute to several tens of minutes. In addition, the temperature may be raised stepwise by combining these temperatures, and for example, heat treatment may be performed at 70°C, 80°C, and 90°C for 1 minute each.

### <Pattern formation>

Next, a method for pattern-processing a negative photosensitive resin composition varnish or a negative photosensitive resin composition film using the same, a method for thermocompression bonding to another member, and a method for bonding another substrate via a pattern produced on a substrate will be described by giving examples.

First, a method for forming a negative photosensitive resin composition coating film on a substrate using the negative photosensitive resin composition of the present invention or a negative photosensitive resin composition film using the same will be described.

When the negative photosensitive resin composition varnish is used, the varnish is first applied onto a substrate. Examples of the application method include methods such as spin coating using a spinner, spray coating, roll coating, screen printing, etc. In addition, although the applied film thickness varies depending on the application method, the solid content concentration and viscosity of the negative photosensitive resin composition, and the like, the application is usually preferably performed so that the film thickness after drying is 0.5 µm or more and 100 µm or less. Next, the substrate onto which the negative photosensitive resin composition varnish has been applied is dried to obtain a negative photosensitive resin composition coating film laminated on the substrate. For drying, an oven, a hot plate, infrared rays, or the like can be used. The drying temperature and drying time may be in a range in which the organic solvent can be volatilized, and it is preferable to appropriately set a range such that the negative photosensitive resin composition coating film is in an uncured or semi-cured state. Specifically, it is preferably performed in a range of 50 to 150°C for 1 minute to several hours.

When the negative photosensitive resin composition film is used, if it has a protective film, this is peeled off, the negative photosensitive resin composition film and a substrate are made to face each other, and they are bonded together by thermocompression bonding to obtain a negative photosensitive resin composition coating film laminated on the substrate. The thermocompression bonding can be performed by a thermal press treatment, a thermal lamination treatment, a thermal vacuum lamination treatment, or the like. The bonding temperature is preferably 40°C or more from the viewpoint of adhesiveness to the substrate and embedding properties. In addition, the bonding temperature is preferably 150°C or less in order to prevent the negative photosensitive resin composition film from being cured during bonding and the resolution of pattern formation in exposure and development steps from being deteriorated.

In any case, examples of the substrate used include silicon wafers, ceramics, gallium arsenide, organic circuit boards, inorganic circuit boards, and those in which circuit constituent materials are arranged on these substrates, but are not limited thereto. Examples of organic circuit boards include glass base copper-clad laminates such as glass cloth-epoxy copper-clad laminates; composite copper-clad laminates such as glass non-woven fabric-epoxy copper-clad laminates; heat-resistant/thermoplastic substrates such as polyetherimide resin substrates, polyetherketone resin substrates, and polysulfone-based resin substrates; and flexible substrates such as polyester copper-clad film substrates and polyimide copper-clad film substrates. In addition, examples of inorganic circuit boards include ceramic substrates such as alumina substrates, aluminum nitride substrates, and silicon carbide substrates; and metal-based substrates such as aluminum-based substrates and iron-based substrates. Examples of circuit constituent materials include conductors containing metals such as silver, gold, and copper; resistors containing inorganic oxides and the like; low-dielectric materials containing glass-based materials and/or resins and the like; high-dielectric materials containing resins, high-dielectric-constant inorganic particles, and the like; and insulators containing glass-based materials and the like.

Next, the negative photosensitive resin composition coating film formed by the above method is irradiated with actinic rays through a mask having a desired pattern to be exposed. As the actinic rays used for exposure, there are ultraviolet rays, visible rays, electron beams, X-rays, and the like, and in the present invention, it is preferable to use the i-line (365 nm), h-line (405 nm), or g-line (436 nm) of a mercury lamp. In the negative photosensitive resin composition film, when the support is a material transparent to these light rays, exposure may be performed without peeling the support from the negative photosensitive resin composition film.

To form a pattern, after exposure, an unexposed part of the negative photosensitive resin composition coating film is removed using a developer. As the developer, an aqueous solution of a compound showing alkalinity is preferred, such as an aqueous solution of tetramethylammonium hydroxide, diethanolamine, diethylaminoethanol, sodium hydroxide, potassium hydroxide, sodium carbonate, potassium carbonate, triethylamine, diethylamine, methylamine, dimethylamine, dimethylaminoethyl acetate, dimethylaminoethanol, dimethylaminoethyl methacrylate, cyclohexylamine, ethylenediamine, or hexamethylenediamine. In some cases, these aqueous alkaline solutions may contain polar solvents such as N-methyl-2-pyrrolidone, N,N-dimethylformamide, N,N-dimethylacetamide, dimethyl sulfoxide, γ-butyrolactone, and dimethylacrylamide; alcohols such as methanol, ethanol, and isopropanol; esters such as ethyl lactate and propylene glycol monomethyl ether acetate; or ketones such as cyclopentanone, cyclohexanone, isobutyl ketone, and methyl isobutyl ketone, alone or in combination of several kinds.

Development can be performed by a method such as spraying the above developer onto the coating film surface, puddling the developer on the coating film surface, immersing in the developer, or immersing and applying ultrasonic waves. Development conditions such as development time, development steps, and the temperature of the developer may be any conditions as long as the unexposed part is removed and pattern formation is possible.

After development, it is preferred to perform a rinsing treatment with water. Here, a rinsing treatment may be performed by adding alcohols such as ethanol and isopropyl alcohol, or esters such as ethyl lactate and propylene glycol monomethyl ether acetate to water.

In addition, a bake treatment may be performed before development as necessary. Thereby, the resolution of the pattern after development may be improved and the permissible range of development conditions may be increased. The bake treatment temperature is preferably in a range of 50 to 180°C, and more preferably in a range of 60 to 120°C. The time is preferably 5 seconds to several hours.

After pattern formation, a cationic polymerizable compound or a photocationic polymerization initiator that has not reacted remains in the negative photosensitive resin composition coating film. For this reason, these may be thermally decomposed during thermocompression bonding or curing to generate gas. To avoid this, it is preferred to irradiate the entire surface of the negative photosensitive resin composition coating film after pattern formation with the above-described exposure light to generate an acid from the photocationic polymerization initiator. By doing so, the reaction of the unreacted cationic polymerizable compound proceeds during thermocompression bonding or curing, and the generation of gas derived from thermal decomposition can be suppressed.

After development, a thermal crosslinking reaction is allowed to proceed by applying a temperature of 150°C to 500°C. By crosslinking, heat resistance and chemical resistance can be improved. As the method of this heat treatment, a method of selecting a temperature and raising the temperature stepwise, or a method of selecting a certain temperature range and carrying out the treatment for 5 minutes to 5 hours while continuously raising the temperature can be selected. As an example of the former, a method of performing heat treatment at 130°C and 200°C for 30 minutes each can be mentioned. As an example of the latter, a method such as linearly raising the temperature from room temperature to 400°C over 2 hours can be mentioned.

After the resin composition pattern is formed on a substrate as described above, another substrate is made to face the resin composition pattern and thermocompression bonding is performed, whereby the two substrates can be bonded. The thermocompression bonding can be performed by a thermal press treatment, a thermal lamination treatment, a thermal vacuum lamination treatment, or the like. The temperature during compression bonding is preferably 60°C or more from the viewpoint of adhesiveness to the substrate. In addition, the temperature during compression bonding is preferably 180°C or less in order to reduce warping of the substrate after compression bonding.

The substrates bonded by thermocompression bonding can be subjected to a thermal crosslinking reaction by applying a temperature of 150°C to 500°C, if necessary. By crosslinking, heat resistance and chemical resistance can be improved. As the method of this heat treatment, the same method as the heat treatment after development described above can be used.

### <Cured film, Semiconductor device>

The cured film of the present invention is one obtained by curing the negative photosensitive resin composition of the present invention or the negative photosensitive resin composition coating film of the present invention. In the present invention, curing means allowing a thermal crosslinking reaction to proceed by applying a temperature of 150°C to 500°C to the negative photosensitive resin composition of the present invention or the negative photosensitive resin composition coating film of the present invention. The cured film of the present invention can be used for electronic components such as semiconductor devices.

One embodiment of the electronic component of the present invention is an electronic component having the cured film of the present invention. Here, the electronic component refers to general devices that can function by utilizing characteristics of a semiconductor element or the like. Electro-optical devices and semiconductor circuit boards in which a semiconductor element is connected to a substrate, those in which a plurality of semiconductor elements are laminated, and electronic devices including these are all included in electronic components. In addition, multilayer wiring boards and the like for connecting semiconductor elements are also included in electronic components. The cured film of the present invention is suitably used for various electronic components. Specifically, it is suitably used for applications such as an interlayer insulating film of an inductor, a passivation film of a semiconductor, a surface protective film of a semiconductor element, an interlayer insulating film between a semiconductor element and wiring, an interlayer insulating film between a plurality of semiconductor elements, an interlayer insulating film between wiring layers of multilayer wiring for high-density mounting, an insulating layer of an organic electroluminescence element, an interlayer insulating film of a probe card, an interlayer insulating film of a magnetic sensor, a structural member of a wavelength selection filter, and an adhesive member of a wavelength selection filter, etc., but is not limited thereto and can be used for various applications.

Further, the negative photosensitive resin composition of the present invention is capable of bonding two substrates by thermocompression bonding of another substrate via a resin composition pattern formed on a substrate. That is, one embodiment of the electronic component of the present invention is an electronic component having a structure in which two substrates are bonded via the negative photosensitive resin composition of the present invention. Since the negative photosensitive resin composition of the present invention has good resolution and adhesiveness as described above, it is possible to replace a part where a metal was conventionally used as a bonding member with the negative photosensitive resin composition of the present invention, and it becomes possible to produce an electronic component that is low-cost, small, and low-profile. By curing the negative photosensitive resin composition of the present invention after bonding, an electronic component having a structure in which two substrates are bonded via the cured film of the present invention is obtained. Examples of the electronic component having a structure in which two substrates are bonded include, but are not limited to, a semiconductor package, a multilayer wiring board for high-density mounting, a wavelength selection filter, and the like.

### [Examples]

The present invention will be specifically described below based on examples, but the present invention is not limited thereto.

### <Pattern processability evaluation>

A 5 cm square silicon substrate was prepared as a substrate. The protective film of the negative photosensitive resin composition film produced in each of Examples and Comparative Examples described later was peeled off, and the resin composition film was placed on the substrate so that the peeled surface faced the substrate. Using a vacuum diaphragm type laminator (MVLP-500/600, manufactured by Meiki Co., Ltd.), lamination was performed under conditions of upper and lower hot plate temperatures of 80°C, a vacuum suction time of 20 seconds, a vacuum press time of 30 seconds, and a bonding pressure of 0.5 MPa to form a resin composition coating film having a thickness of 10 µm on the silicon substrate. Subsequently, after the support was peeled off from the resin composition coating film of the resin composition film, a mask having patterns of line-and-space (L/S) of 5 µm/5 µm, 10 µm/10 µm, 15 µm/15 µm, 20 µm/20 µm, 25 µm/25 µm, 30 µm/30 µm, 40 µm/40 µm, and 50 µm/50 µm was set in an exposure apparatus, and exposure was performed using an ultra-high pressure mercury lamp with an i-line bandpass filter under a condition of an exposure gap of 100 µm between the mask and the resin composition coating film. After the exposure, post-exposure baking was performed on a hot plate at 90°C for 10 minutes. Thereafter, an unexposed part of the resin composition coating film was removed by dip development using a 2.38% by mass aqueous solution of tetramethylammonium hydroxide, and a rinsing treatment with water was performed. The development time was set to twice the time required for the unexposed part to be completely dissolved.

The resin composition pattern obtained in this way was observed with an optical microscope, and the minimum L/S size at which there were no abnormalities such as distortion, clogging, or peeling in the pattern was defined as the resolution. For a resin composition in which an abnormality occurred in all patterns, "0" was described in the column of resolution.

<Adhesiveness evaluation>

In the same manner as in the pattern processability evaluation, the silicon substrate was replaced with a glass substrate, and a resin composition coating film having a thickness of 10 µm was formed on the glass substrate. Subsequently, the entire surface of the resin composition coating film was exposed using an ultra-high pressure mercury lamp with an i-line bandpass filter. After the exposure, post-exposure baking was performed on a hot plate at 90°C for 10 minutes, and then a dip development treatment was performed using a 2.38% by mass aqueous solution of tetramethylammonium hydroxide. The exposure amount and development time at this time were the same as the conditions when the resolution was minimum in the aforementioned pattern processability evaluation.

A 5 cm square silicon substrate was placed so as to face the resin composition coating film after the development treatment, and thermocompression bonding was performed using a vacuum diaphragm type laminator (MVLP-500/600, manufactured by Meiki Co., Ltd.) under conditions of a vacuum suction time of 20 seconds, a vacuum press time of 120 seconds, and a bonding pressure of 0.3MPa. At this time, the test was conducted by changing the upper and lower hot plate temperatures to 120°C, 150°C, and 180°C.

The bonded surface between the resin composition coating film and the silicon substrate after the thermocompression bonding was observed with an optical microscope from the glass substrate side to confirm whether the entire surface was bonded without voids. At this time, the hot plate temperature during the thermocompression bonding at which bonding without voids was possible was defined as the bonding temperature. For a resin composition in which voids occurred on the bonded surface under all conditions, "-" was described in the column of bonding temperature.

The compounds used in Examples and Comparative Examples are shown below.

### (A) Cationic polymerizable compound

(A1-1) (A liquid polyfunctional aromatic glycidyl ether having an epoxy equivalent of 111 g/eq and a viscosity at 25°C of 400 mPa·s)
(A1-2) (A liquid polyfunctional aromatic glycidyl ether having an epoxy equivalent of 113 g/eq and a viscosity at 25°C of 112,000 mPa·s)
(A-1) (A polyfunctional aliphatic epoxy compound having an epoxy equivalent of 127 g/eq, corresponding to general formula (1))
(A-2) (A polyfunctional aromatic glycidyl ether having an epoxy equivalent of 170 g/eq)
(A-3) (A polyfunctional aromatic glycidylamine having an epoxy equivalent of 115 g/eq)
(A-4) OGSOL (registered trademark) EG-280 (manufactured by Osaka Gas Chemicals Co., Ltd.) (A polyfunctional aromatic glycidyl ether having an epoxy equivalent of 460 g/eq, corresponding to general formula (2))

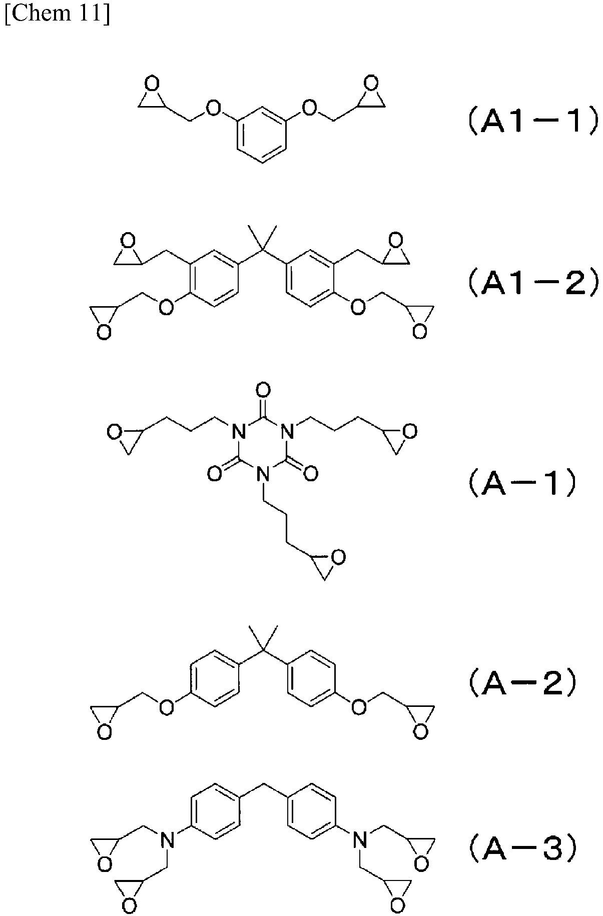

### (B) Photocationic polymerization initiator

CPI-310FG (manufactured by San-Apro Ltd.)
Silane coupling agent
X-12-967C (manufactured by Shin-Etsu Chemical Co., Ltd.).

### Synthesis Example 1: Synthesis of polyimide (C-1)

Under a dry nitrogen stream, 2,2-bis(3-amino-4-hydroxyphenyl)hexafluoropropane (hereinafter referred to as BAHF) (29.30 g, 0.08 mol) was added to 80 g of γ-butyrolactone (hereinafter referred to as GBL) and stirred and dissolved at 120°C. Next, 4-(2,5-dioxotetrahydrofuran-3-yl)-1,2,3,4-tetrahydronaphthalene-1,2-dicarboxylic dianhydride (hereinafter referred to as TDA-100) (30.03 g, 0.1 mol) was added together with 20 g of GBL, and the mixture was stirred at 120°C for 1 hour, and then stirred at 200°C for 4 hours to obtain a reaction solution. Next, the reaction solution was poured into 3 L of water to collect a white precipitate. This precipitate was collected by filtration, washed with water three times, and then dried in a vacuum dryer at 80°C for 5 hours to obtain polyimide (C-1).

### Synthesis Example 2: Synthesis of polyimide (C-2)

Polyimide (C-2) was obtained in the same manner as in Synthesis Example 1 except that bis(3-amino-4-hydroxyphenyl)fluorene (hereinafter referred to as FHDA) (26.63 g, 0.07 mol) was used instead of BAHF (29.30 g, 0.08 mol).

### Synthesis Example 3: Synthesis of polyimide (C-3)

Polyimide (C-3) was obtained in the same manner as in Synthesis Example 1 except that 2,2-bis(3-amino-4-hydroxyphenyl)propane (hereinafter referred to as BAP) (20.67 g, 0.08 mol) was used instead of BAHF (29.30 g, 0.08 mol).

### Synthesis Example 4: Synthesis of polyimide (C-4)

Polyimide (C-4) was obtained in the same manner as in Synthesis Example 1 except that bis(3-amino-4-hydroxyphenyl)sulfone (hereinafter referred to as ABPS) (22.43 g, 0.08 mol) was used instead of BAHF (29.30 g, 0.08 mol).

### Synthesis Example 5: Synthesis of polyimide (C-5)

Polyimide (C-5) was obtained in the same manner as in Synthesis Example 1 except that 1,3-bis(4-amino-3-hydroxyphenoxy)benzene (hereinafter referred to as AHPB) (22.70 g, 0.07 mol) was used instead of BAHF (29.30 g, 0.08 mol).

### Synthesis Example 6: Synthesis of polyimide (C-6)

Polyimide (C-6) was obtained in the same manner as in Synthesis Example 1 except that 3,5-diaminobenzoic acid (hereinafter referred to as DABA) (7.61 g, 0.05 mol) and 1,3-bis(3-aminopropyl)-1,1,3,3-tetramethyldisiloxane (hereinafter referred to as SiDA) (9.94 g, 0.04 mol) were used instead of BAHF (29.30 g, 0.08 mol).

### Example 1

6 g of epoxy compound (A1-1) as the component (A), 0.3 g of CPI-310FG (trade name, manufactured by San-Apro Ltd.) as the component (B), 3.5 g of polyimide (C-1) as the component (C), and 0.2 g of X-12-967C (trade name, manufactured by Shin-Etsu Chemical Co., Ltd.) as a silane coupling agent were dissolved in GBL. The amount of solvent added was adjusted so that additives other than the solvent were taken as a solid content, and the solid content concentration was 60% by mass. The resulting solution was subjected to pressure filtration using a filter having a retained particle size of 1 µm to obtain a negative photosensitive resin composition varnish.

The obtained negative photosensitive resin composition varnish was applied onto a 50 µm thick PET film using a comma roll coater, and dried at 120°C for 8 minutes. Then, a 30 µm thick polypropylene (PP) film was laminated as a protective film to obtain a negative photosensitive resin composition film. The thickness of the negative photosensitive resin composition coating film was adjusted to 10µm. Using the obtained negative photosensitive resin composition film, pattern processability evaluation, adhesiveness evaluation, and degree of reaction evaluation of cationic polymerizable groups were performed as described above. The results are shown in Table 2.

### Examples 2 to 10

Negative photosensitive resin composition films were produced in the same manner as in Example 1 except that the components (A) to (C) and other components were changed to compounds shown in Table 1, and pattern processability evaluation, adhesiveness evaluation, and degree of reaction evaluation of cationic polymerizable groups were performed as described above. The results are shown in Table 2.

### Comparative Examples 1 to 4

Resin composition films were produced in the same manner as in Example 1 except that the components (A) to (C) and other components were changed to compounds having structures shown in Table 1, and pattern processability evaluation, adhesiveness evaluation, and degree of reaction evaluation of cationic polymerizable groups were performed as described above. The results are shown in Table 2.

**Table 1-1**

| | | | Ex. 1 | Ex. 2 | Ex. 3 | Ex. 4 | Ex. 5 | Ex. 6 | Ex. 7 | Ex. 8 | Ex. 9 |
|---|---|---|---|---|---|---|---|---|---|---|---|
| Component (A) (mass %) | Component (A1) (mass %) | A1-1 | 60 | - | - | - | - | - | - | - | - |
| | | A1-2 | - | 60 | 48 | 40 | 36 | 30 | 24 | 48 | 30 |
| | Component (A) other than Component (A1) (mass %) | A-1 | - | - | 12 | 20 | 24 | 30 | 16 | 32 | 30 |
| | | A-2 | - | - | - | - | - | - | - | - | - |
| | | A-3 | - | - | - | - | - | - | - | - | - |
| | | A-4 | - | - | - | - | - | - | - | - | - |
| Component (B) (mass %) | | CPI-310FG | 3 | 3 | 3 | 3 | 3 | 3 | 3 | 3 | 3 |
| Component (C) (mass %) | | C-1 | 35 | 35 | 35 | 35 | 35 | 35 | 55 | 15 | - |
| | | C-2 | - | - | - | - | - | - | - | - | 35 |
| | | C-3 | - | - | - | - | - | - | - | - | - |
| | | C-4 | - | - | - | - | - | - | - | - | - |
| | | C-5 | - | - | - | - | - | - | - | - | - |
| | | C-6 | - | - | - | - | - | - | - | - | - |
| Silane coupling agent (mass %) | | X-12-967C | 2 | 2 | 2 | 2 | 2 | 2 | 2 | 2 | 2 |
| Content of Component (A1) in total Component (A) (mass %) | | | 100 | 100 | 80 | 66.7 | 60 | 50 | 60 | 60 | 50 |
| Content of Component (A1) in total negative photosensitive resin composition (mass %) | | | 60 | 60 | 60 | 60 | 60 | 60 | 40 | 80 | 60 |

| | | | | | | | | | | | |
|---|---|---|---|---|---|---|---|---|---|---|---|
| Ex.: Example | | | | | | | | | | | |

**Table 1-2**

| | | | Ex. 10 | Ex. 11 | Ex. 12 | Ex. 13 | Ex. 14 | Comp. Ex. 1 | Comp. Ex. 2 | Comp. Ex. 3 | Comp. Ex. 4 |
|---|---|---|---|---|---|---|---|---|---|---|---|
| Component (A) (mass %) | Component (A1) (mass %) | A1-1 | - | - | - | - | - | - | - | - | - |
| | | A1-2 | 30 | 30 | 30 | 30 | 30 | - | - | - | 24 |
| | Component (A) other than Component (A1) (mass %) | A-1 | | 30 | 30 | 30 | 30 | 60 | 30 | 30 | 36 |
| | | A-2 | - | - | - | - | - | - | 30 | - | - |
| | | A-3 | - | - | - | - | - | - | - | 30 | - |
| | | A-4 | 30 | - | - | - | - | - | - | - | - |
| Component (B) (mass %) | | CPI-310FG | 3 | 3 | 3 | 3 | 3 | 3 | 3 | 3 | 3 |
| Component (C) (mass %) | | C-1 | - | - | - | - | - | 35 | 35 | 35 | 35 |
| | | C-2 | 35 | - | - | - | - | - | - | - | - |
| | | C-3 | - | 35 | - | - | - | - | - | - | - |
| | | C-4 | - | - | 35 | - | - | - | - | - | - |
| | | C-5 | - | - | - | 35 | - | - | - | - | - |
| | | C-6 | - | - | - | - | 35 | - | - | - | - |
| Silane coupling agent (mass %) | | X-12-967C | 2 | 2 | 2 | 2 | 2 | 2 | 2 | 2 | 2 |
| Content of Component (A1) in total Component (A) (mass %) | | | 50 | 50 | 50 | 50 | 50 | 0 | 0 | 0 | 40 |
| Content of Component (A1) in total negative photosensitive resin composition (mass %) | | | 60 | 60 | 60 | 60 | 60 | 60 | 60 | 60 | 60 |

| | | | | | | | | | | | |
|---|---|---|---|---|---|---|---|---|---|---|---|
| Ex.: Example, Comp. Ex.: Comparative Example | | | | | | | | | | | |

**Table 2-1**

| | | Example 1 | Example 2 | Example 3 | Example 4 | Example 5 | Example 6 | Example 7 | Example 8 | Example 9 |
|---|---|---|---|---|---|---|---|---|---|---|
| Pattern processability evaluation | Resolution (µm) | 15 | 15 | 10 | 5 | 5 | 5 | 10 | 30 | 10 |
| Adhesiveness evaluation | Bonding temperature (° C) | 180 | 120 | 120 | 120 | 120 | 150 | 150 | 120 | 120 |

**Table 2-2**

| | | Ex.10 | Ex. 11 | Ex. 12 | Ex. 13 | Ex. 14 | Comp. Ex. 1 | Comp. Ex. 2 | Comp. Ex. 3 | Comp. Ex. 4 |
|---|---|---|---|---|---|---|---|---|---|---|
| Pattern processability evaluation | Resolution (µm) | 10 | 20 | 20 | 10 | 15 | 5 | 15 | 0 | 5 |
| Adhesiveness evaluation | Bonding temperature (° C) | 120 | 150 | 150 | 150 | 150 | - | - | - | - |

| | | | | | | | | | | |
|---|---|---|---|---|---|---|---|---|---|---|
| Ex.: Example, Comp. Ex.: Comparative Example | | | | | | | | | | |

As is clear from Table 1 and Table 2, in Comparative Examples 1 to 4, voids occurred on the bonded surface under any of the conditions in the adhesiveness evaluation.

In contrast, it was shown that the negative photosensitive resin composition of this example achieves both excellent resolution and adhesiveness.

Further, by comparing Example 1 and Example 2, it was shown that by containing, as the component (A1), a liquid polyfunctional aromatic glycidyl ether having a viscosity at 25°C of 10,000 to 150,000 mPa·s, the adhesiveness is further improved and bonding is possible even under lower temperature conditions for thermocompression bonding.

Furthermore, by comparing Example 5 with Examples 7 and 8, it was shown that more excellent resolution and adhesiveness are obtained when the content of the component (A) in the entire negative photosensitive resin composition is 45 to 70% by mass.

## Claims

1. A negative photosensitive resin composition comprising a cationic polymerizable compound as Component (A) and a photocationic polymerization initiator as Component (B),
wherein Component (A) contains, as Component (A1), a polyfunctional aromatic glycidyl ether having an epoxy equivalent of 80 to 145 g/eq and having at least two or more epoxy groups in a molecule, and
the content of Component (A1) in the total Component (A) is 45 to 100% by mass.

2. The negative photosensitive resin composition according to claim 1, wherein the content of Component (A) in the total negative photosensitive resin composition is 45 to 70% by mass.

3. The negative photosensitive resin composition according to claim 1, wherein Component (A1) contains a liquid polyfunctional aromatic glycidyl ether having a viscosity at 25°C of 10,000 to 150,000 mPa·s.

4. The negative photosensitive resin composition according to claim 1, wherein Component (A) contains a cationic polymerizable compound selected from compounds represented by the following general formulas (1) and (2): 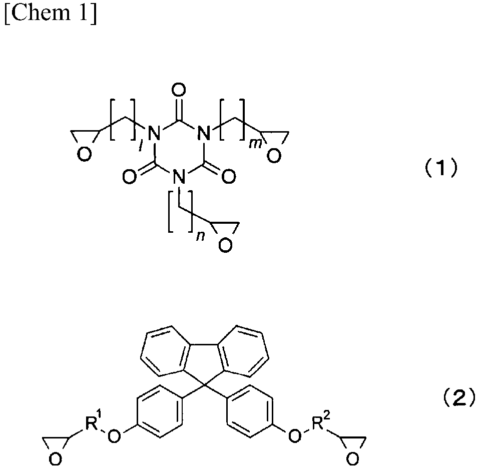 wherein, in general formula (1), l, m, and n are each independently an integer of 1 to 6; and in general formula (2), R¹ and R² are each independently a divalent organic group.

5. The negative photosensitive resin composition according to claim 1, further comprising at least one polymer compound selected from polyamide, polyimide, and polyamide-imide as Component (C).

6. The negative photosensitive resin composition according to claim 5, wherein Component (C) contains a diamine residue derived from any of diamines of the following general formulas (3) to (7):

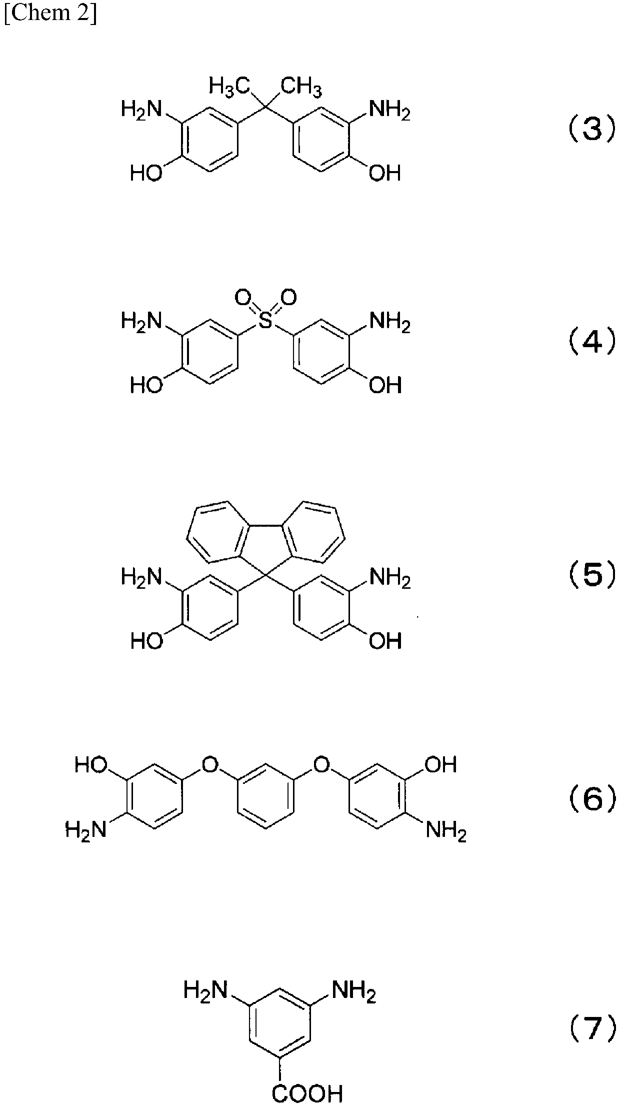

7. A negative photosensitive resin composition coating film comprising the negative photosensitive resin composition according to claim 1.

8. A negative photosensitive resin composition film comprising the negative photosensitive resin composition coating film according to claim 7 and a support.

9. A cured film obtained by curing the negative photosensitive resin composition according to claim 1 or the negative photosensitive resin composition coating film according to claim 7.

10. An electronic component comprising the cured film according to claim 9.

11. An electronic component comprising a structure in which two substrates are bonded via the cured film according to claim 9.
